# EUROPEAN PATENT APPLICATION

(11) **EP 3 148 092 A1**
(43) Date of publication of application: **29.03.2017**
(21) Application number: 14892478.0
(22) Date of filing: 23.05.2014
(51) Int. Cl.: H03M 13/35, H03M 13/07

(54) **COMPUTATION CIRCUIT, ENCODING CIRCUIT, AND DECODING CIRCUIT**

(71) Applicant: Fujitsu Limited, Kawasaki-shi, Kanagawa 211-8588 (JP)
(72) Inventor: TOMITA, Yoshinori, Kawasaki-shi Kanagawa 211-8588 (JP)
(74) Representative: Chew, Kwan Chong Daniel
(86) International application number: PCT/JP2014/063659
(87) International publication number: WO 2015/177917

(57) **Abstract**

In order to speed up computation processing, memories (M0 to M15) retain data blocks on which exclusive logical OR computation is performed, and selection circuits (2a to 2p) receive a selection signal and select two or more data blocks for use in exclusive logical OR computation from among a plurality of data blocks read from the memories (M0 to M15) on the basis of the selection signal, and XOR circuits (3a to 3o) (exclusive logical OR computation circuits) perform exclusive logical OR computation based on the two or more data blocks selected by the selection circuits (2a to 2p).

## Description

### Technical Field

The embodiments discussed herein relate to a computation circuit, an encoding circuit, and a decoding circuit.

### Background Art

XOR (exclusive logical OR) computation is performed to generate a parity bit that is added to transmission data, for example.

In recent years, random packet stream (RPS) technology is proposed to prevent decrease of communication speed due to packet loss that occurs in communication using TCP (transmission control protocol)/IP (Internet Protocol). The RPS technology is a technology that automatically generates a packet that is lost during data transfer. In the RPS technology, a transmitter device performs XOR computation between data blocks of constant data sizes a plurality of times, in order to generate encoded data (redundant data) that is used in packet restoration.

### Citation List

### Patent Literature

PTL1: Japanese Laid-open Patent Publication No. 11-237997
PTL2: Japanese Laid-open Patent Publication No. 2001-147827
PTL3: Japanese Laid-open Patent Publication No. 11-102301

### Summary of Invention

### Technical Problem

By the way, a process that repeats XOR computation for a combination of data blocks a plurality of times, like an encoding process by the RPS technology, takes a processing time if performed by software, and thus is possibly unable to catch up with a situation where communication speed becomes faster.

Thus, it is conceived to perform XOR computation by hardware. However, it is possible that simple change from software to hardware does not contribute to speeding up of the computation. For example, when a data transfer speed of a memory is slow, it takes a long processing time to repeat a process of storing a result of XOR computation between certain data blocks into the memory and then performing XOR computation between the result and another data block.

### Solution to Problem

According to one aspect, there is provided a computation circuit including: a plurality of memories configured to retain data blocks on which exclusive logical OR computation is performed; a plurality of selection circuits configured to receive a selection signal and select two or more data blocks for use in exclusive logical OR computation from among a plurality of data blocks that are read from the plurality of memories, on the basis of the selection signal; and one or a plurality of exclusive logical OR computation circuits configured to perform exclusive logical OR computation based on the two or more data blocks selected by the plurality of selection circuits.

According to another aspect, there is provided an encoding circuit including: a plurality of memories configured to retain data blocks on which exclusive logical OR computation is performed; a plurality of selection circuits configured to receive a selection signal and select two or more data blocks for use in exclusive logical OR computation from among a plurality of data blocks that are read from the plurality of memories, on the basis of the selection signal; and one or a plurality of exclusive logical OR computation circuits configured to generate encoded data by performing exclusive logical OR computation based on the two or more data blocks selected by the plurality of selection circuits.

According to yet another aspect, there is provided a decoding circuit including: a plurality of memories configured to retain data blocks, the data blocks being encoded data on which exclusive logical OR computation is performed; a plurality of selection circuits configured to receive a selection signal and select two or more data blocks for use in exclusive logical OR computation from among a plurality of data blocks that are read from the plurality of memories, on the basis of the selection signal; and one or a plurality of exclusive logical OR computation circuits configured to generate decoded data by performing exclusive logical OR computation based on the two or more data blocks selected by the plurality of selection circuits.

### Advantageous Effects of Invention

The disclosed computation circuit, the encoding circuit, and the decoding circuit can speed up computation processing.

The above and other purposes, features, and advantages of the present disclosure will be obvious from the following description with reference to the appended drawings illustrating preferable embodiments as examples of the present disclosure.

### Brief Description of Drawings

[FIG. 1] FIG. 1 illustrates an example of a computation circuit according to a first embodiment.
[FIG. 2] FIG. 2 is a diagram for describing an example of an RPS encoding process.
[FIG. 3] FIG. 3 illustrates an example of an information processing apparatus.
[FIG. 4] FIG. 4 is a diagram for describing an example of an FPGA that performs an RPS encoding process.
[FIG. 5] FIG. 5 illustrates an example of an encoding circuit according to a second embodiment.
[FIG. 6] FIG. 6 illustrates an example of a control circuit.
[FIG. 7] FIG. 7 illustrates an example of an RPS encoding matrix.
[FIG. 8] FIG. 8 is a flowchart illustrating a sequence of an example of an RPS encoding process.
[FIG. 9] FIG. 9 is a diagram for describing an example of a decoding process for decoding encoded data obtained by an RPS encoding process.
[FIG. 10] FIG. 10 illustrates an example of a decoding circuit according to the second embodiment.
[FIG. 11] FIG. 11 is a diagram for describing exemplary generation of a reception encoding matrix.
[FIG. 12] FIG. 12 illustrates an example of a generated reception encoding matrix.
[FIG. 13] FIG. 13 is a flowchart illustrating a sequence of an exemplary generation process of a decode vector.
[FIG. 14] FIG. 14 illustrates an example of an updated reception encoding matrix.
[FIG. 15] FIG. 15 illustrates an example of a matrix ops.
[FIG. 16] FIG. 16 illustrates an example of a relationship between column vectors (decode vectors) of a matrix ops and data blocks that are decoded by using the column vectors.
[FIG. 17] FIG. 17 is a first diagram illustrating an exemplary variant of an encoding circuit according to the second embodiment.
[FIG. 18] FIG. 18 is a second diagram illustrating an exemplary variant of an encoding circuit according to the second embodiment.
[FIG. 19] FIG. 19 is a third diagram illustrating an exemplary variant of an encoding circuit according to the second embodiment.
[FIG. 20] FIG. 20 is a diagram for describing a sequence of an exemplary encoding process.

### Description of Embodiments

In the following, embodiments for performing the disclosure will be described with reference to drawings.

### (First Embodiment)

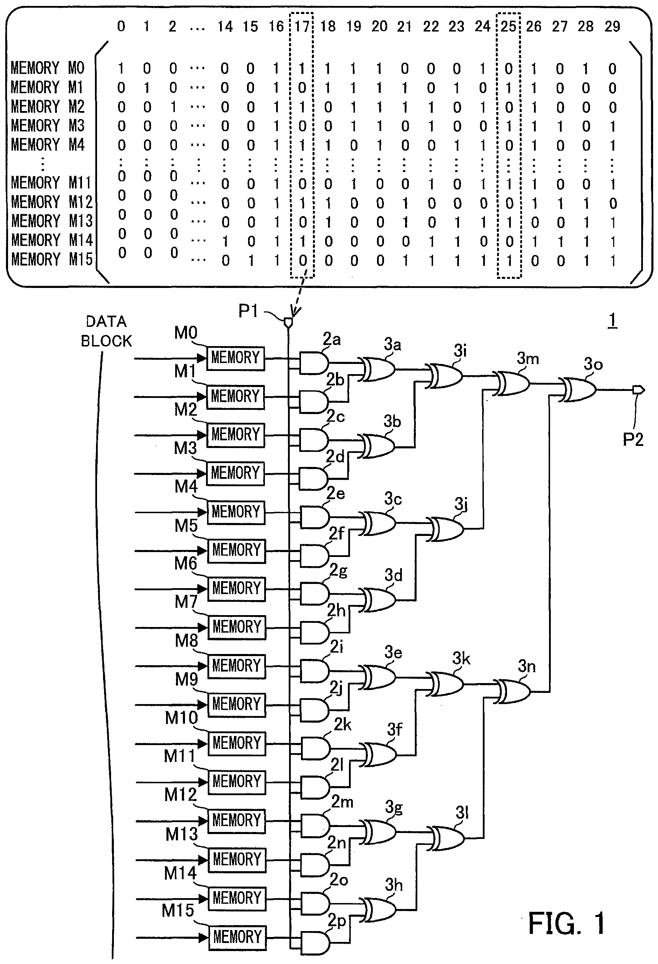

FIG. 1 illustrates an example of a computation circuit according to a first embodiment.

The computation circuit 1 is an encoding circuit for performing an encoding process or a decoding circuit for performing a decoding process, for example.

The computation circuit 1 includes memories M0 to M15, selection circuits 2a to 2p, XOR circuits 3a to 3o, an input terminal P1 into which a selection signal is input, and an output terminal P2 from which an XOR computation result is output. Note that signal lines that connect between those circuit elements may be a bundle of a plurality of bits, such as 64 bits wide.

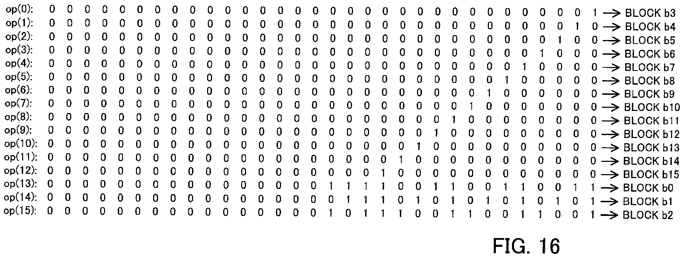

The memories M0 to M15 are random access memories (RAMs) for example, and retain a plurality of data blocks, each of which is a data unit on which XOR computation is performed. Encode target data is divided into data blocks of constant data sizes, for example. In the example of FIG. 1, 16 pieces of data blocks are retained in the memories M01 to M15, respectively. Also, the memories M0 to M15 output the retained data blocks to the selection circuits 2a to 2p, respectively.

The selection circuits 2a to 2p receive a selection signal input from the input terminal P1 and select whether or not to use the data blocks retained in the memories M0 to M15 in XOR computation on the basis of the selection signal. AND circuits (logical AND computation circuits) can be used as the selection circuits 2a to 2p. The selection circuits 2a to 2p can be formed as simple circuits if the AND circuits are used, but are not limited to the AND circuits.

In the following description, the selection circuits 2a to 2p are assumed to be the AND circuits.

The selection circuits 2a to 2p perform AND computation between the data blocks output by the memories M0 to M15 and the 16-bit selection signal, and outputs computation results to the XOR circuits 3a to 3h. In this case, one or more of the data blocks retained in the memories M0 to M15 are output from the selection circuits 2a to 2p in accordance with the bits whose values are "1" in the 16-bit selection signal input from the input terminal P1.

In the upper side of FIG. 1, an example of an RPS encoding matrix is illustrated, assuming that the computation circuit 1 performs an encoding process of the RPS technology (hereinafter, referred to as an RPS encoding process). The RPS encoding matrix is stored in a memory unit (not depicted), and 16-bit column vectors are sequentially input as selection signals into the input terminal P1. The RPS encoding matrix of FIG. 1 is a matrix of 16 rows by 30 columns. The rows in a column vector correspond to the memories M0 to M15. That is, when the value of a certain row in a column vector is "1", the data block retained in the memory corresponding to the row is used in XOR computation.

For example, when the column vector of column number 17 is input from the input terminal P1, the data blocks retained in the memories M0, M2, M4, ... , M12, M14, which correspond to 1st, 3rd, 5th, ... , 13th, 15th lines, are output from the selection circuits 2a, 2c, 2e, ... , 2m, 2o.

Also, when the column vector of column number 25 is input from the input terminal P1, the data blocks retained in the memories M1, M3, ... , M11, M13, M15, which correspond to 2nd, 4th, ... , 12th, 14th, 16th lines, are output from the selection circuits 2b, 2d, ... , 21, 2n, 2p.

The XOR circuits 3a to 3o perform XOR computation based on data blocks that are selected by the selection circuits 2a to 2p. An XOR computation result is output from the output terminal P2.

Two input terminals of the XOR circuit 3a are connected to output terminals of the selection circuits 2a and 2b, and two input terminals of the XOR circuit 3b are connected to output terminals of the selection circuits 2c and 2d. Also, two input terminals of the XOR circuit 3c are connected to output terminals of the selection circuits 2e and 2f, and two input terminals of the XOR circuit 3d are connected to output terminals of the selection circuits 2g and 2h. Also, two input terminals of the XOR circuit 3e are connected to output terminals of the selection circuits 2i and 2j, and two input terminals of the XOR circuit 3f are connected to output terminals of the selection circuits 2k and 21. Also, two input terminals of the XOR circuit 3g are connected to output terminals of the selection circuits 2m and 2n, and two input terminals of the XOR circuit 3h are connected to output terminals of the selection circuits 2o and 2p.

Two input terminals of the XOR circuit 3i are connected to output terminals of the XOR circuits 3a and 3b, and two input terminals of the XOR circuit 3j are connected to output terminals of the XOR circuits 3c and 3d. Also, two input terminals of the XOR circuit 3k are connected to output terminals of the XOR circuits 3e and 3f, and two input terminals of the XOR circuit 31 are connected to output terminals of the XOR circuits 3g and 3h. Two input terminals of the XOR circuit 3m are connected to output terminals of the XOR circuits 3i and 3j, and two input terminals of the XOR circuit 3n are connected to output terminals of the XOR circuits 3k and 31. Two input terminals of the XOR circuit 3o are connected to output terminals of the XOR circuits 3m and 3n, and an output terminal of the XOR circuit 3o is connected to the output terminal P2.

In the example of FIG. 1, the XOR circuits 3a to 3o are connected in a tree shape (a knockout tournament shape) as described above. Note that the XOR circuits are not limited to the ones that receive two inputs, but may be the ones that receive 3 or more inputs, and for example a single XOR circuit may perform XOR computation of the data blocks output from the selection circuits 2a to 2p.

### (Exemplary Operation of Computation Circuit 1)

In the following, an exemplary operation of the computation circuit 1 will be described. Note that, in the following description, the column vectors of the RPS encoding matrix illustrated in FIG. 1 are selection signals that are input into the selection circuits 2a to 2p.

The column vectors of column numbers 0 to 29 are sequentially input into the input terminal P1 as the selection signals.

In each of the column vectors of column numbers 0 to 15, the value of a certain row is 1, and the values of other rows are 0. When this column vector is input into the input terminal P1 as a selection signal, a data block retained in a memory corresponding to the row whose value is 1 is output from one of the selection circuits 2a to 2p. 0 is output from the other selection circuits.

Thereby, a data block retained in one of the memories M0 to M15 is output, as it is, from the XOR circuit 3o of the last stage in the XOR circuits 3a to 3o having the above connection relationship.

In each of the column vectors of column numbers 16 to 29, the values of a plurality of rows are 1. When this column vector is input into the input terminal P1 as a selection signal, a plurality of data blocks retained in the memories corresponding to the rows whose values are 1 are output from two or more of the selection circuits 2a to 2p. 0 is output from the other selection circuits.

Thereby, the XOR circuit 3o of the last stage in the XOR circuits 3a to 3o having the above connection relationship outputs a result of XOR computation of a plurality of data blocks that are output from two or more of the selection circuits 2a to 2p.

As described above, the computation circuit 1 according to the present embodiment once retains each data block in the memories M0 to M15, and selects one or more data blocks that are used in the computation of the selection circuits 2a to 2p from among a plurality of data blocks that are read out from the memories M0 to M15, and supplies the selected data block(s) to the XOR circuits 3a to 3o. This parallel processing makes computation more efficient to achieve high speed computation, when many XOR computations are performed for a plurality of combinations of data blocks, as in the RPS encoding process.

### (Second Embodiment)

The following description explains an encoding circuit of a transmission circuit for performing an RPS encoding process and a decoding circuit of a reception circuit for decoding encoded data that is encoded in the RPS encoding process, as examples of a computation circuit for performing XOR computation.

First, an example of the RPS encoding process will be described.

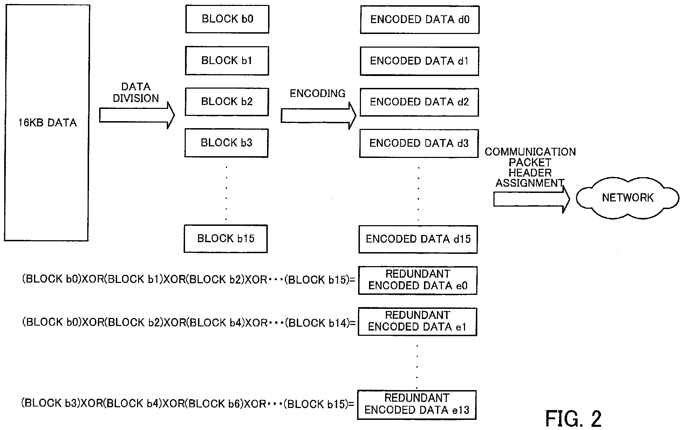

FIG. 2 is a diagram for describing an example of the RPS encoding process.

First, in the RPS encoding process, data is divided into data blocks of constant sizes. Here, for the purpose of explanation, 16KB data is divided into 16 pieces of 1KB data blocks, and the divided terminal blocks are referred to as blocks b0 to b15.

Next, the encoding circuit selects one or more blocks from the blocks b0 to b15 obtained by dividing the data, and generates encoded data d0 to d15 and redundant encoded data e0 to e13 by performing XOR computation of the selected blocks.

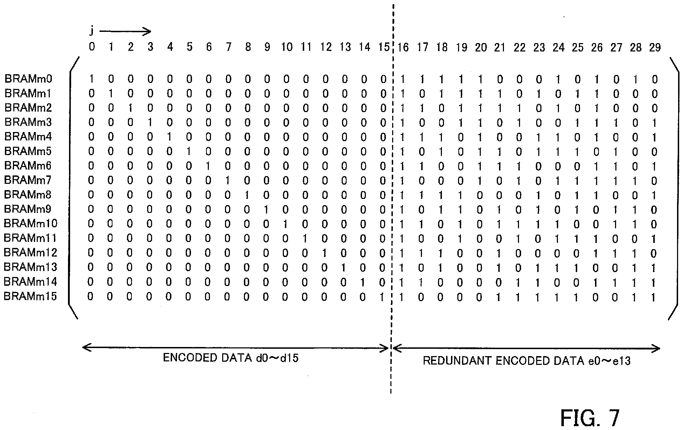

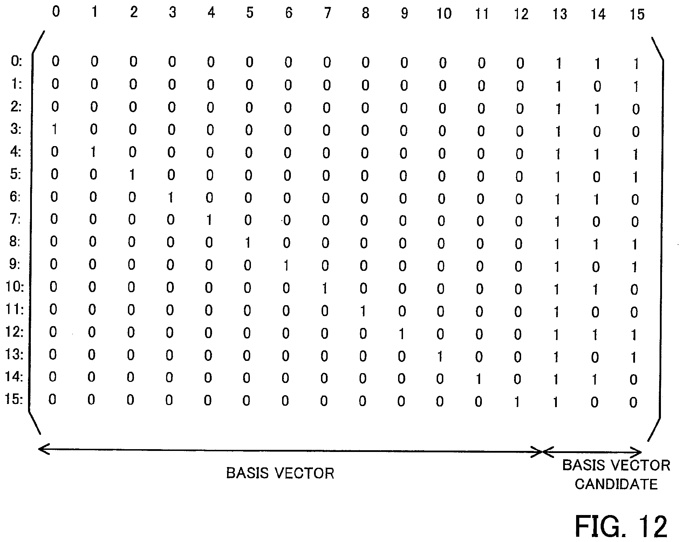

Thereafter, combination information (column vectors of an RPS encoding matrix of FIG. 7 in the later described example) is added to the encoded data and the redundant encoded data, i.e. to packet headers of packets, and after the communication packet headers are given, the encoded data and the redundant encoded data are transmitted by user datagram protocol (UDP) communication. In this case, even when a packet is lost or replaced on a transmission route, a reception side can decode original transmission data by applying a Gaussian elimination method or the like to the received encoded data and redundant encoded data and the received combination information (a reception encoding matrix of FIG. 12 in the later described example).

Next, an example of an information processing apparatus for use in data communication will be described.

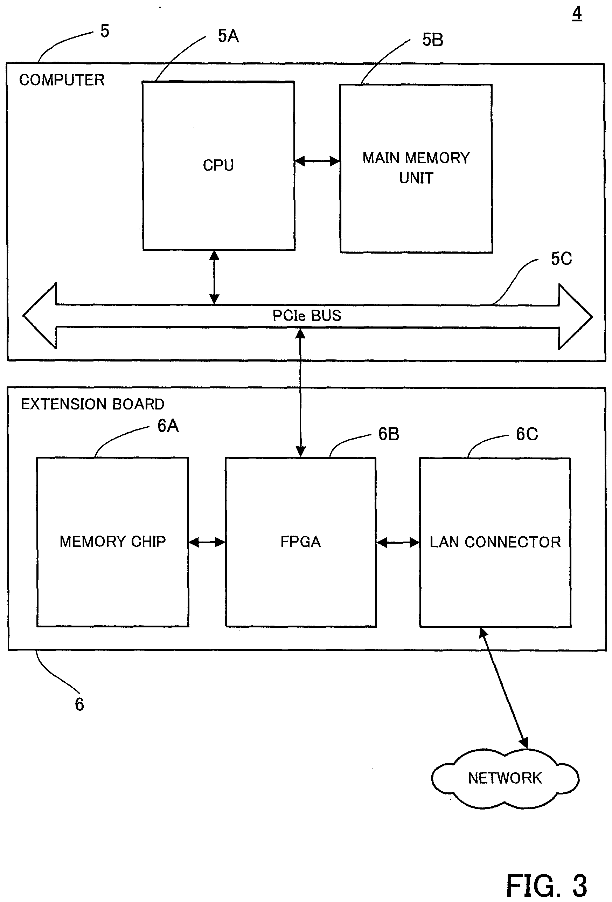

FIG. 3 illustrates an example of the information processing apparatus.

The information processing apparatus 4 includes a computer 5 and a function extension board 6 provided in the computer 5. The computer 5 includes a central processing unit (CPU) 5A, a main memory unit 5B, and a PCI express (PCIe) bus 5C. A memory chip 6A, a field-programmable gate array (FPGA) 6B, and a local area network (LAN) connector 6C are mounted on the function extension board 6. Also, the CPU 5A and the FPGA 6B are connected via the PCIe bus 5C.

The CPU 5A reads transmission data from a hard disk drive (HDD) (not depicted) or the like and stores in the main memory unit 5B. Also, the CPU 5A instructs the FPGA 6B to execute an RPS encoding process, for example.

The main memory unit 5B stores the transmission data and various types of data for use in the process by the CPU 5A. A RAM is used as the main memory unit 5B, for example.

The memory chip 6A stores data that is transferred from the main memory unit 5B by a direct memory access (DMA) controller in the FPGA 6B. A RAM is used in the memory chip 6A, for example.

The FPGA 6B performs an RPS encoding process to the data and generates communication packets and outputs the generated packets to the LAN connector 6C.

The LAN connector 6C transfers the packets output by the FPGA 6B to a receiver device (not depicted) via a network.

### (Example of FPGA 6B)

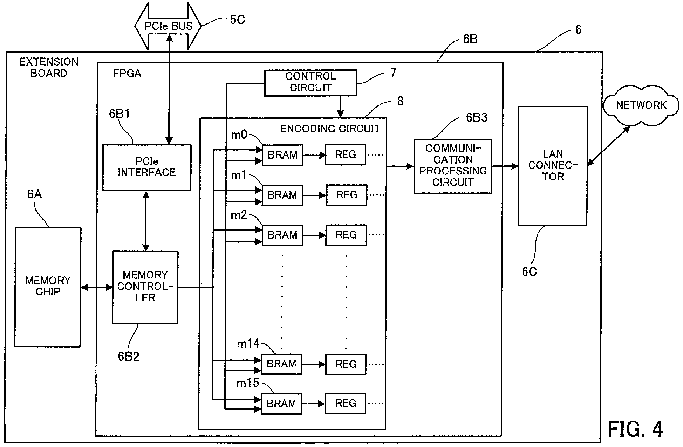

FIG. 4 is a diagram for describing an example of the FPGA that performs an RPS encoding process.

Note that FIG. 4 does not depict a part that executes a control and a function other than the RPS encoding process of transmission data.

The FPGA 6B includes a PCIe interface 6B1, a memory controller 6B2, a communication processing circuit 6B3, a control circuit 7, and an encoding circuit 8.

The PCIe interface 6B1 is a PCIe end point for an I/O device and the like and performs a process of a physical layer or a data link layer to the data transferred via the PCIe bus 5C.

The memory controller 6B2 is a memory interface that divides the data stored in the memory chip 6A into data blocks of constant sizes and transfers the data blocks to block RAMs (BRAMs) m0 to m15. The memory controller 6B2 divides 16KB data into 16 pieces of blocks b0 to b15 of constant sizes 1KB and transfers the blocks b0 to b15 to the BRAMs m0 to m15, as illustrated in FIG. 2 for example.

The communication processing circuit 6B3 generates communication packets by performing processes of a network layer, a data link layer, and a physical layer to the encoded data and the redundant encoded data which are output by the encoding circuit 8, and outputs the generated packets to the LAN connector 6C.

The control circuit 7 controls the encoding circuit 8 to generate encoded data. A circuit configuration of the control circuit 7 will be described later.

The encoding circuit 8 generates encoded data by performing XOR computation of a plurality of data blocks. In the example of FIG. 2, the encoding circuit 8 performs XOR computation of the blocks b0 to b15 to generate the encoded data d0 to d15 and the redundant encoded data e0 to e13.

### (Example of Encoding Circuit 8)

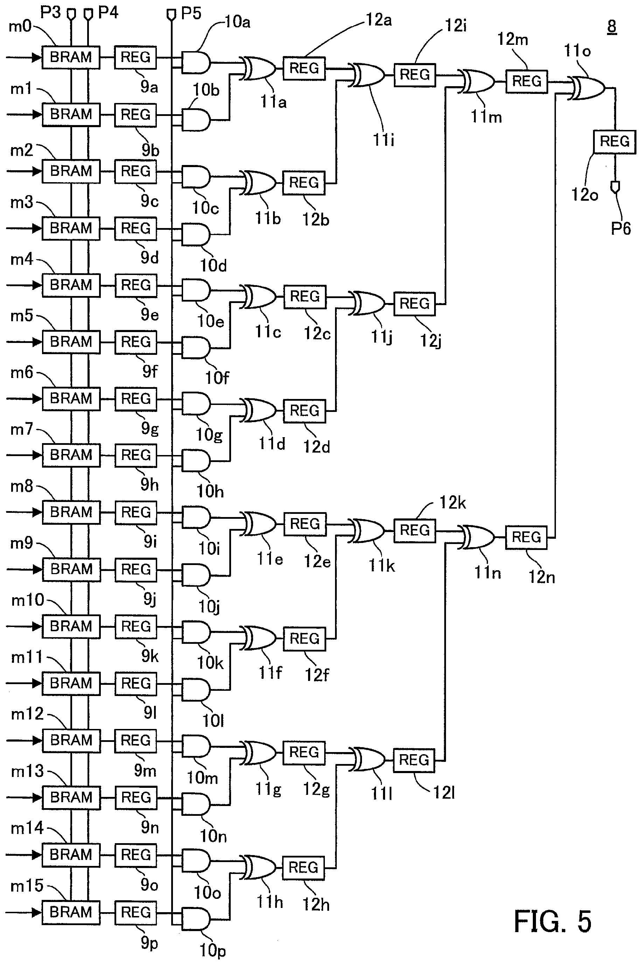

FIG. 5 illustrates an example of the encoding circuit according to the second embodiment.

The encoding circuit 8 includes BRAMs m0 to m15, registers 9a to 9p, AND circuits 10a to 10p, XOR circuits 11a to 11o registers 12a to 12o, input terminals P3, P4, and P5, and an output terminal P6.

A write enable (WE) signal that enables write of a data block into the BRAMs m0 to m15 is input into the input terminal P3 from the control circuit 7.

A write address signal which is used when the BRAMs m0 to m15 write data blocks, as well as a read address signal which is used when the BRAMs m0 to m15 read data blocks and output the read data blocks to the AND circuits 10a to 10p, is input into the input terminal P4 from the control circuit 7.

A column vector of an RPS encoding matrix described later is input into the input terminal P5 from the control circuit 7, so that respective elements of the column vector are input into the AND circuits 10a to 10p.

16 pieces of divided data blocks of constant sizes are supplied from the memory chip 6A to the encoding circuit 8 via the memory controller 6B2.

When a write address signal and a WE signal are input from the control circuit 7 via the input terminals P3 and P4, the BRAMs m0 to m15 write and store 16 pieces of supplied data blocks, for example the blocks b0 to b15 of FIG. 2, in such a manner that each of the BRAMs m0 to m15 writes and stores a data block. Also, when a read address signal is input from the control circuit 7 via the input terminal P3, the BRAMs m0 to m15 each read out the stored data blocks and output the data blocks to the registers 9a to 9p, for example as 64-bit data pieces which are output one after another.

The registers 9a to 9p are connected between the BRAMs m0 to m15 and the AND circuit 10a to 10b, respectively. The registers 9a to 9p retain the data blocks output by the BRAMs m0 to m15 and adjust when to output the retained data blocks to the AND circuits. For example, the registers 9a to 9b retain and output the data blocks supplied from the BRAMs m0 to m15 in synchronization with clock signals (not depicted). When the distances from the BRAMs m0 to m15 to the AND circuits 10a to 10p are various, input time points into the AND circuits 10a to 10p can be made identical by providing the registers 9a to 9p at the input sides of the AND circuits 10a to 10p.

The AND circuits 10a to 10p serve as selection circuits. The AND circuits 10a to 10p perform AND computation between the data blocks output from the BRAMs m0 to m15 and the respective values of the RPS encoding matrix input from the input terminal P5 (which correspond to a selection signal), and output computation results to the XOR circuits 11a to 11h. In this case, the AND circuits 10a to 10p select and output the data blocks retained in the BRAMs m0 to m15 corresponding to the rows at which values of a column vector input via the input terminal P5 is "1". Column vectors of an RPS encoding matrix will be described later.

The XOR circuits 11a to 11o perform XOR computation of the data blocks that the AND circuits 10a to 10p have selected and output, and output a computation result to the output terminal P6.

Two input terminals of the XOR circuit 11a are connected to output terminals of the AND circuits 10a and 10b, and two input terminals of the XOR circuit 11b are connected to output terminals of the AND circuits 10c and 10d. Also, two input terminals of the XOR circuit 11c are connected to output terminals of the AND circuits 10e and 10f, and two input terminals of the XOR circuit 11d are connected to output terminals of the AND circuits 10g and 10h. Also, two input terminals of the XOR circuit 11e are connected to output terminals of the AND circuits 10i and 10j, and two input terminals of the XOR circuit 11f are connected to output terminals of the AND circuits 10k and 101. Also, two input terminals of the XOR circuit 11g are connected to output terminals of the AND circuits 10m and 10n, and two input terminals of the XOR circuit 11h are connected to output terminals of the AND circuits 10o and 10p.

Two input terminals of the XOR circuit 11i are connected to output terminals of the XOR circuits 11a and 11b via the registers 12a and 12b. Two input terminals of the XOR circuit 11j are connected to output terminals of the XOR circuits 11c and 11d via the registers 12c and 12d. Also, two input terminals of the XOR circuit 11k are connected to output terminals of the XOR circuits 11e and 11f via the registers 12e and 12f. Also, two input terminals of the XOR circuit 111 are connected to output terminals of the XOR circuits 11g and 11h via the registers 12g and 12h. Two input terminals of the XOR circuit 11m are connected to output terminals of the XOR circuits 11i and 11j via the registers 12i and 12j. Two input terminals of the XOR circuit 11n are connected to output terminals of the XOR circuits 11k and 111 via the registers 12k and 121. Two input terminals of the XOR circuit 11o are connected to output terminals of the XOR circuits 11m and 11n via the registers 12m and 12n, and an output terminal of the XOR circuit 11o are connected to the output terminal P6 via the register 12o. The output terminal P6 outputs a result of XOR computation between data blocks by the XOR circuits 11a to 11o as encoded data (including the aforementioned encoded data and the redundant encoded data) to the communication processing circuit 6B3 (FIG. 4).

The registers 12a to 12p have the same function as the registers 9a to 9p and adjust when to input and output data between the XOR circuits 11a to 11o.

In the example of FIG. 5, the XOR circuits 11a to 11o are connected in a tree shape (a knockout tournament shape) over a plurality of stages, as described above. Note that the XOR circuits are not limited to the ones that receive 2 inputs, but may be the ones that receive 3 or more inputs, and for example one XOR circuit may perform XOR computation of the data blocks that are output from the AND circuits 10a to 10p.

### (Example of Control Circuit 7)

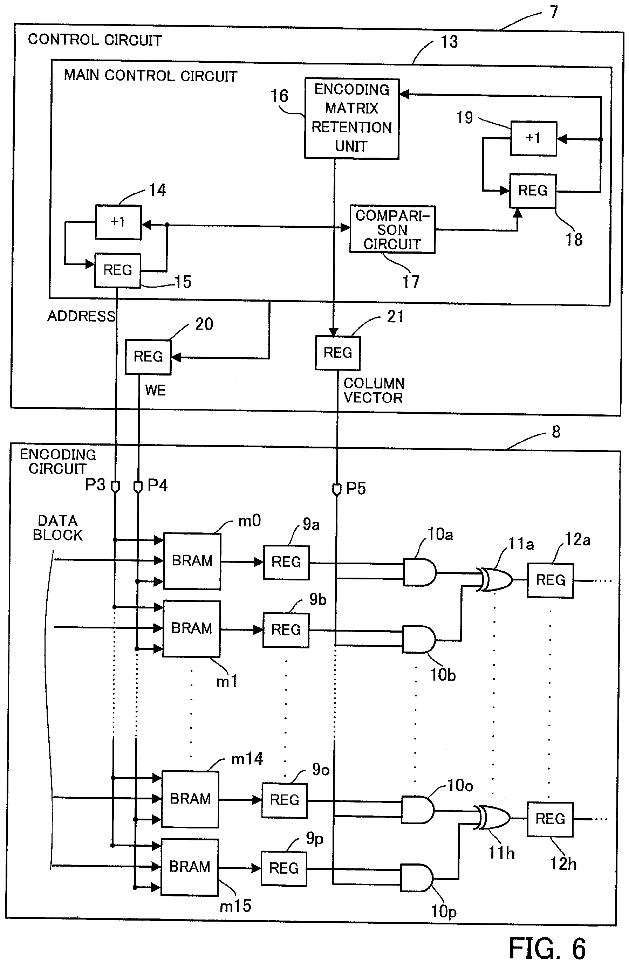

FIG. 6 illustrates an example of the control circuit.

A part of the encoding circuit 8 is depicted to describe connection between the control circuit 7 and the encoding circuit 8.

Note that FIG. 6 depicts only a part that controls an encoding process.

The control circuit 7 includes a main control circuit 13. The main control circuit 13 includes an adder 14, a register 15, an encoding matrix retention unit 16, a comparison circuit 17, a register 18, and an adder 19. In addition, the control circuit 7 includes registers 20 and 21.

For example, the adder 14 includes a flip-flop that retains 1 in order to increment (+1) an address that is retained in the register 15.

The register 15 retains write addresses and read addresses of the BRAMs m0 to m15 and outputs the retained write addresses and the read addresses to the BRAMs m0 to m15 via the input terminal P3. The register 15 retains an address generated by the adder 14, which adds +1 to the retained address in synchronization with clock signals (not depicted).

For example, the encoding matrix retention unit 16 includes a plurality of registers to store an RPS encoding matrix.

FIG. 7 illustrates an example of the RPS encoding matrix.

The RPS encoding matrix illustrated in FIG. 7 is a matrix of 16 rows by 30 columns.

Encoded data is generated by an RPS encoding process for each column vector of the RPS encoding matrix. The column vectors of column numbers 0 to 15 in the RPS encoding matrix are used in generating the encoded data d0 to d15 in the example of FIG. 2. Also, the column vectors of column numbers 16 to 29 in the RPS encoding matrix are used in generating the redundant encoded data e16 to e29 in the example of FIG. 2.

Rows in a column vector correspond to the BRAMs m0 to m15. That is, when the value of a certain row in a column vector is "1", the data block retained in the BRAM corresponding to the row is used in XOR computation.

The encoding matrix retention unit 16 of FIG. 6 outputs a column vector of the RPS encoding matrix, according to the column number output from the register 18, to the register 21. In an initial state, the value that is retained in the register 18 is 0, and thus the encoding matrix retention unit 16 outputs a column vector of column number 0 (j=0) to the register 21.

The comparison circuit 17 determines whether one data block (for example, 1KB) has been written into the BRAMs m0 to m15 on the basis of the number of incrementing by the adder 14, and when one data block is written, outputs a set signal to the register 18.

The register 18 retains a column number of the RPS encoding matrix. Also, upon receiving the set signal output by the comparison circuit 17, the register 18 retains an updated value of the column number generated by the adder 19, which adds +1 to the retained column number in synchronization with clock signals (not depicted).

For example, the adder 19 includes a flip-flop that retains 1, in order to increment the column number retained in the register 18.

When write into the BRAMs m0 to m15 is to be enabled, the register 20 retains a WE signal generated by a WE signal generation unit (not depicted) in the main control circuit 13. Also, the register 20 outputs the retained WE signal to the BRAMs m0 to 15 via the input terminal P4.

The register 21 outputs respective values of a column vector of the retained RPS encoding matrix to the AND circuits 10a to 10p via the input terminal P5. For example, the value of the first row of a column vector is input into the AND circuit 10a, and the value of the second row is input into the AND circuit 10b, sequentially.

Note that the encoding circuit 8 according to the present embodiment is included in the FPGA 6B, but may be configured with an application specific integrated circuit (ASIC) or the like.

### (Example of RPS Encoding Process)

In the following, an example of the RPS encoding process by the encoding circuit 8 will be described.

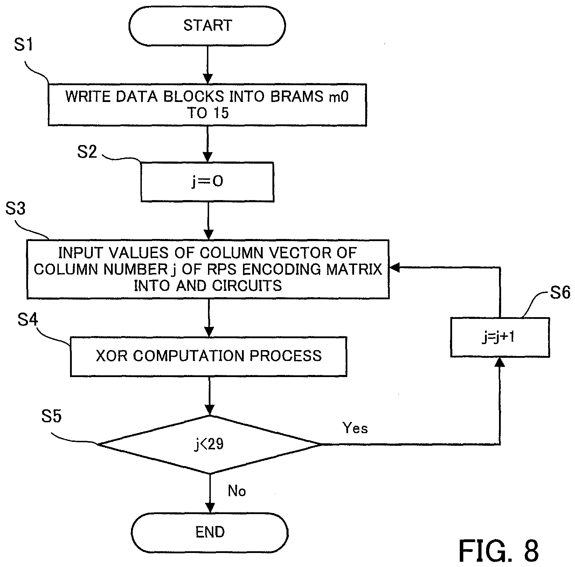

FIG. 8 is a flowchart illustrating an exemplary sequence of the RPS encoding process.

First, data blocks are written into the BRAMs m0 to m15 (step S1). In step S1, the control circuit 7 asserts a WE signal and supplies write addresses to the BRAMs m0 to 15. Then, the BRAMs m0 to m15 write 16 pieces of data blocks which are obtained from the memory chip 6A via the memory controller 6B2 and divided into constant sizes.

Also, the main control circuit 13 sets the column number j to 0 (step S2). In step S2, the initial value of the register 18 of the main control circuit 13 is set to 0.

Next, the control circuit 7 inputs respective values of the column vector of the column number j of the RPS encoding matrix into the AND circuits 10a to 10p (step S3). In step S3, the register 21 illustrated in FIG. 6 inputs the respective values of the column vector of the column number j of the retained RPS encoding into the AND circuits 10a to 10p via the input terminal P5.

For example, the value of the first row of the column vector of the column number j is input into the AND circuit 10a, and the value of the second row is input into the AND circuit 10b sequentially. In this case, the AND circuits 10a to 10p perform AND computation between the values of the column vector of the column number j and the data blocks of the BRAMs m0 to 15, and outputs computation results to the XOR circuits 11a to 11h. Thereby, the AND circuits 10a to 10p select the data blocks retained in the BRAMs m0 to 15 according to the rows of the column vector at which the values are "1", and output the selected data blocks to the XOR circuits 11a to 11h. For example, when the column vector of column number 0 (j=0) in the RPS encoding matrix illustrated in FIG. 7 is input into the AND circuits 10a to 10p, only the value of the first row is "1", and thus the AND circuit 10a that receives the value of the first row selects and outputs the data block of the BRAM m0.

Thereafter, the encoding circuit 8 performs XOR computation (step S4). In step S4, the XOR circuits 11a to 11h perform XOR computation using the data blocks retained in the BRAMs m0 to m15.

In each column vector whose column number j is 0 to 15, the value of a certain row is 1, and the values of other rows are 0. When this column vector is input into the input terminal P5, the data block retained in the BRAM corresponding to the row whose value is 1 is output as it is, from the XOR circuit 11o of the last stage in the XOR circuits 11a to 11o having the above connection relationship.

In each column vector of column number 16 to 29, the values of a plurality of rows are 1. When this column vector is input into the input terminal P5, a result of XOR computation of a plurality of data blocks output from two or more of the AND circuits 10a to 10p is output from the XOR circuit 11o of the last stage in the XOR circuits 11a to 11o having the above connection relationship.

Next, the main control circuit 13 determines whether or not the column number j has reached the maximum value of 29 (step S5), and while the column number j is smaller than 29, adds +1 to the column number j by means of the adder 19 (step S6). After step S6, the process returns to step S3.

When the column number j reaches 29, the RPS encoding process for one data block is completed. When the encoding circuit 8 performs the RPS encoding process for the next data block, the process starts again from step S1.

Thereafter, the encoded data and the redundant encoded data output from the encoding circuit 8 are processed by the communication processing circuit 6B3 and thereafter are transferred as packets. Also, in this case, the column vector used in encoding is added to the packet header and is transferred together with the encoded data and the redundant encoded data.

As described above, in the encoding circuit 8 according to the present embodiment, the BRAMs m0 to m15 once retain data blocks, and the AND circuits 10a to 10p select data blocks that are used in the computation on the basis of the values of a column vector, and the XOR circuits 11a to 11o perform XOR computation. This parallel processing makes computation more efficient in the RPS encoding process including many XOR computations, and thereby enables high speed computation (encoding process).

Note that, when each of the BRAMs m0 to m15 has a 64 bits × 512 words memory space in the encoding circuit 8, each of the BRAMs m0 to m15 can retain 4 pieces of 1KB data blocks. Thus, the BRAMs m0 to m15 can input 4 pieces of data blocks to the registers 9a to 9p continuously, thereby improving the throughput of the encoding process. Further, if the BRAMs m0 to m15 are configured with dual port memories that can execute read and write simultaneously, a time that it takes to write a new data block into a BRAM can be concealed, and thereby the throughput can be improved more.

Next, an example of a decoding process will be described.

### (Example of Decoding Process)

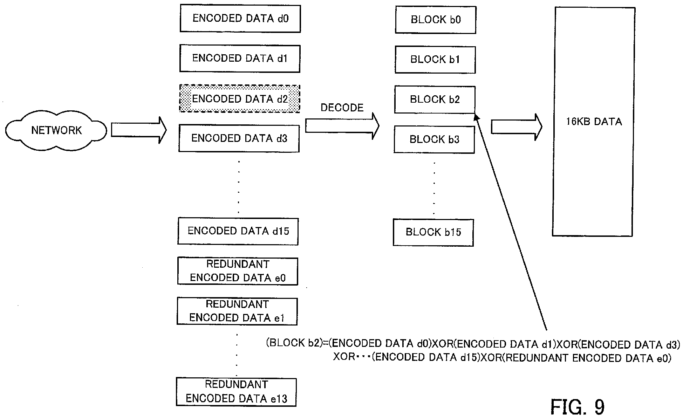

FIG. 9 is a diagram for describing an example of a decoding process for decoding the encoded data obtained by the RPS encoding process.

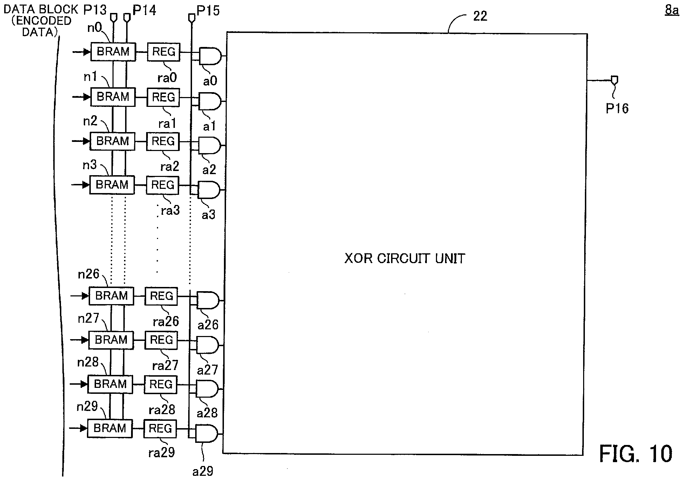

FIG. 9 illustrates a situation of decoding the encoded data d0 to d15 and the redundant encoded data e0 to e13, which are included in the packets sent from the aforementioned encoding circuit 8 to a decoding circuit (refer to FIG. 10) via a network.

The decoding circuit (refer to FIG. 10) extracts combination information of data blocks used in encoding (i.e., a column vector of an RPS encoding matrix) from the header of a received packet.

The encoded data d0, d1, d3 to d15 correspond to the data blocks b0, b1, b3 to b15 and thus are output as they are.

In the example of FIG. 9, a packet that includes the encoded data d2 is lost. The decoding circuit generates (decodes) the block b2 of the lost packet from the received encoded data, the redundant encoded data, and the extracted combination information. For example, the block b2 is generated by XOR computation of the encoded data d0, d1, d3, ... , d15, and the redundant encoded data e0, as illustrated in FIG. 9.

As described above, the decoding circuit also performs XOR computation, and its circuit configuration is the same as the encoding circuit 8.

Next, the decoding circuit used in performing a decoding process will be described with reference to FIG. 10. Note that the decoding circuit may be included in the FPGA 6B illustrated in FIG. 3 together with the encoding circuit 8, for example. A control circuit for controlling the decoding circuit can be configured with the same circuit as the control circuit 7 illustrated in FIG. 6.

### (Example of Decoding Circuit)

FIG. 10 illustrates an example of the decoding circuit according to the second embodiment.

The decoding circuit 8a includes BRAMs n0, n1, n2, n3, ... , n26, n27, n28, n29 and registers ra0, ra1, ra2, ra3, ... , ra26, ra27, ra28, ra29. In addition, the decoding circuit 8a includes AND circuits a0, a1, a2, a3, ... , a26, a27, a28, a29, an XOR circuit unit 22, input terminals P13 to P15, and an output terminal P16.

A WE signal for enabling the BRAMs n0 to n29 to write encoded data and redundant encoded data is input into the input terminal P13.

Write addresses that are used when the BRAMs n0 to n29 write the encoded data and the redundant encoded data, as well as read addresses that are used when the BRAMs n0 to n29 read out the encoded data and the redundant encoded data to output the encoded data and the redundant encoded data to the AND circuits a0 to a29, are input into the input terminal P14.

Respective values of a decode vector described later are input into the input terminal P15 and are supplied to the AND circuits a0 to a29.

When write addresses and a WE signal are input via the input terminals P13 and P14, each of the BRAMs n0 to n29 writes and retains the received encoded data or redundant encoded data, block by block. Also, when read addresses are input via the input terminal P13, the BRAMs n0 to n29 output the retained encoded data and redundant encoded data to the registers ra0 to ra29 respectively, for example as 64 bit data pieces which are output one after another.

There are 30 BRAMs n0 to n29 corresponding to 30 pieces of data blocks (encoded data) output by the encoding circuit 8, that is, the encoded data d0 to d15 and the redundant encoded data e0 to e13. In the same way, there are 30 registers ra0 to ra29 and 30 AND circuits a0 to a29.

The registers ra0 to ra29 have the same function as the registers 9a to 9p illustrated in FIG. 5

The AND circuits a0 to a29 serve as selection circuits in the same way as the AND circuits 10a to 10p illustrated in FIG. 5. The AND circuits a0 to a29 each perform AND computation between the encoded data or the redundant encoded data output by the BRAMs n0 to n29 and the respective values of a decode vector (which serves as a selection signal) input from the input terminal P5. Then, the AND circuits a0 to a29 output computation results to the XOR circuit unit 22. In this case, the AND circuits a0 to a29 each select and output encoded data or redundant encoded data of the BRAMs n0 to n29 in accordance with the rows at which the decode vector (a column vector) input via the input terminal P15 is "1".

The XOR circuit unit 22 is not detailed but is a circuit that includes a plurality of XOR circuits and registers connected in a tree shape, in the same way as the encoding circuit 8 illustrated in FIG. 5, for example.

The XOR circuit unit 22 performs XOR computation of the encoded data or the redundant encoded data that are selected and input by the AND circuits a0 to a29 in order to decode an original data block.

The output terminal P16 outputs a decoded original data block.

In the following, before describing operation of the decoding circuit 8a, a generation process of a decode vector used in a decoding process will be described.

### (Exemplary Generation Process of Decode Vector)

A decode vector is generated by a control circuit (not depicted) for controlling the decoding circuit 8a, for example.

In order to generate a decode vector, a reception encoding matrix is first generated as in the following.

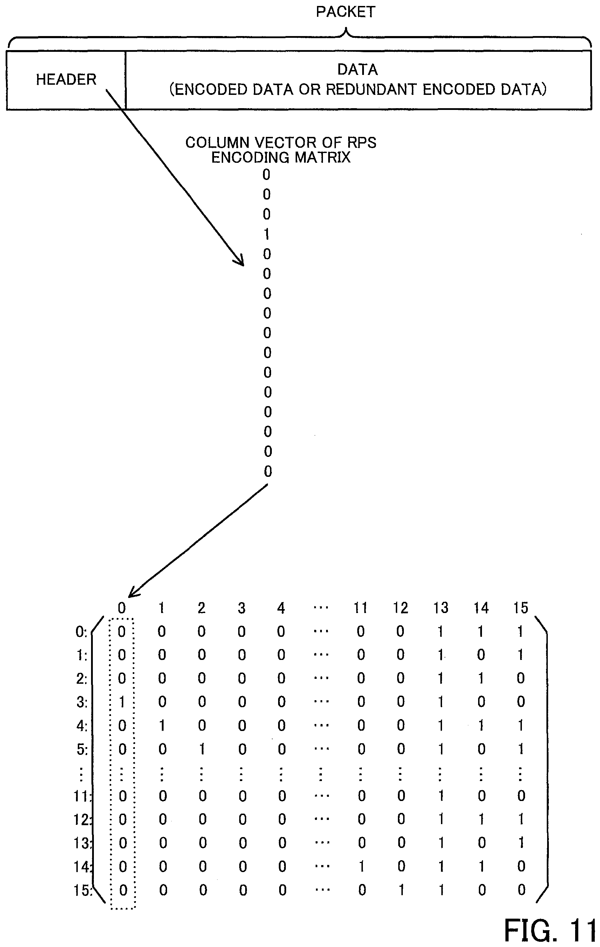

FIG. 11 is a diagram for describing exemplary generation of a reception encoding matrix.

Also, FIG. 12 illustrates an example of a generated reception encoding matrix.

A column vector of an RPS encoding matrix is included in a header of a packet that includes data (encoded data or redundant encoded data) that has been encoded in the RPS encoding process.

For example, each time a control circuit of a reception side receives the above packet, the control circuit extracts the column vector from the header and arranges the extracted column vectors in the order of reception from the column number 0 in order to generate the reception encoding matrix illustrated in FIG. 12.

The reception encoding matrix (16 rows by 16 columns) illustrated in FIG. 12 is generated at a time point when 16 pieces of packets are received. In the following, a column vector of the reception encoding matrix is represented by a column vector D(c) by using a column number c, and the value of the u-th row of a column vector D(c) is represented by element [u], for example.

Note that "basis vector" and "basis vector candidate" illustrated in FIG. 12 will be described later.

A decode vector is generated from the above reception encoding matrix.

The decoding process is similar to a Gaussian elimination method which is known as a method for solving simultaneous linear equations, for example. For example, a simultaneous linear equation can be expressed as AX=C, where A is a matrix which is a coefficient of a solution, and X is a column vector which is a solution, and C is a column vector which is a constant, in the simultaneous linear equation. Then, the Gaussian elimination method is applied to AX=C, in such a manner that the matrix A is set to an identity matrix E, in order to calculate EX=C1, that is, X=C1.

In the decoding process according to the present embodiment, a reception encoding matrix is represented by the matrix A, and an original data block is represented by the column vector X, and encoded data or redundant encoded data is represented by the column vector C.

Here, a decode vector that serves as a selection signal input into the AND circuits a0 to a29 of the decoding circuit 8a is generated as in the following for example, in a control circuit (not depicted) for controlling the decoding circuit 8a for example, on the basis of the reception encoding matrix.

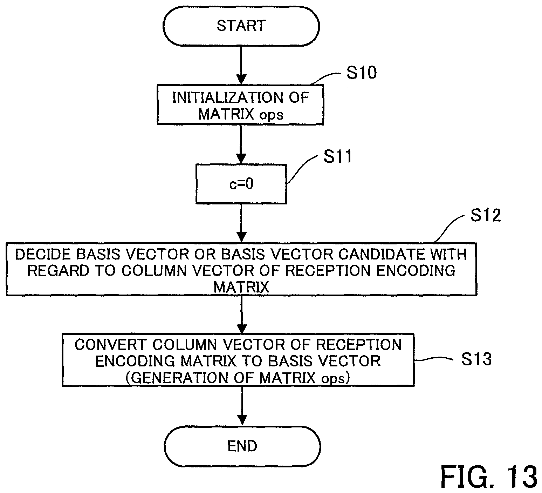

FIG. 13 is a flowchart illustrating a sequence of an exemplary generation process of a decode vector.

First, a matrix ops to which the values of a plurality of decode vectors are assigned is initialized (step S10).

The initialization of the matrix ops is performed by setting 1 to on-diagonal elements and 0 to other elements in the matrix ops, so as to form an identity matrix. Also, the matrix ops has rows and columns of the same number as the columns of a reception encoding matrix.

Next, the column number c of the reception encoding matrix is set to 0 (step S11). The column number c is a variable to which a column number of a basis vector or a basis vector candidate is assigned in step S13 described later.

Thereafter, a basis vector or a basis vector candidate is decided with regard to a column vector included in the reception encoding matrix (step S12).

Only one element is equal to 1 in basis vectors, and the basis vectors are orthogonal to each other. Also, in the following, a basis vector with an element [u] (where u is a row number) equal to 1 is referred to as a basis vector of the element [u]. Given that D[c] is a column vector of column number c in the example of the reception encoding matrix illustrated in FIG. 12, the column vectors D(0) to D(12) whose column numbers c are 0 to 12 are decided as the basis vectors of the element [3] to [12], respectively.

When the basis vector of an element [u] does not exist in the reception encoding matrix, a column vector with the element [u] equal to 1 can be a basis vector candidate. For example, basis vectors of elements [0] to [2] do not exist in the reception encoding matrix illustrated in FIG. 12. Hence, a column vector D(13) with an element [0] equal to 1 is decided as a basis vector candidate of element [0], and a column vector D(14) with an element [2] equal to 1 is decided as a basis vector candidate of element [2]. Also, a column vector D(15) with an element [1] equal to 1 is decided as a basis vector candidate of element [1].

Next, a process for converting column vectors of the reception encoding matrix to basis vectors is performed (step S13).

In step S13, first, a column vector whose element is 1 at a row number that is the same as the element of 1 of a basis vector (or a basis vector candidate) is detected from the reception encoding matrix. Then, the element of the detected column vector is updated with a result of XOR computation between the element and the element of the basis vector. A result of XOR computation between 1 and 1 is 0, and thus the element of the detected column vector becomes 0. This process is repeated for each basis vector (or basis vector candidate) of the reception encoding matrix, and thereby the basis vector candidates of the reception encoding matrix are converted to basis vectors.

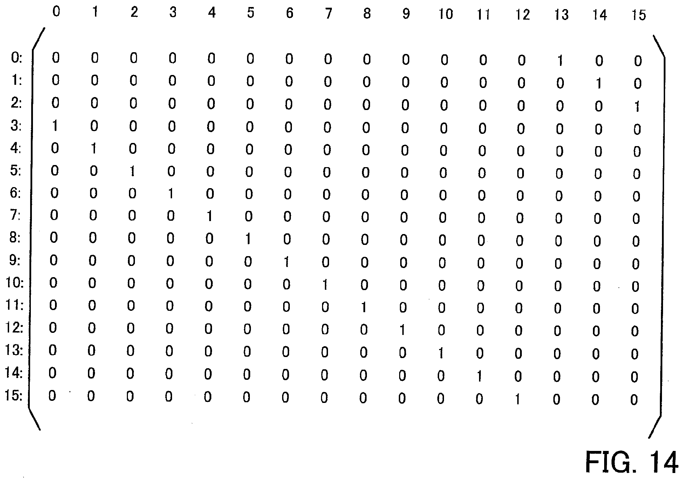

FIG. 14 illustrates an example of the updated reception encoding matrix.

By the process of step S13, the column vectors D(13) to (15), which were the basis vector candidates illustrated in FIG. 12, are converted to the basis vectors of elements [0] to [1] as illustrated in FIG. 14.

Also, in the process of the above step S13, the XOR computation processing results obtained when converting the basis vector candidates of the reception encoding matrix to the basis vectors are assigned to respective elements of the matrix ops, and for example the below matrix ops is generated.

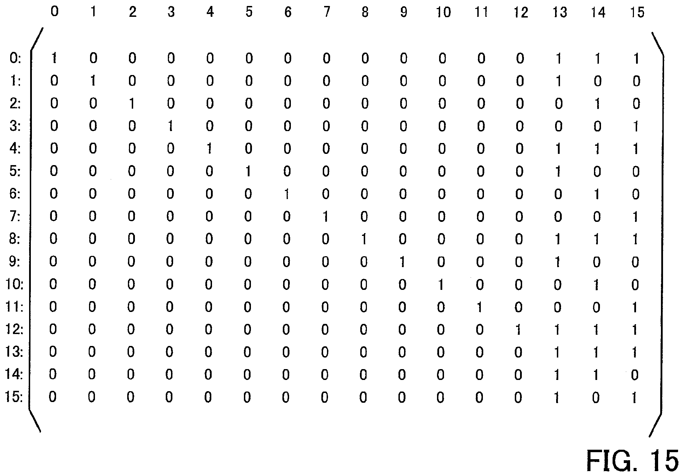

FIG. 15 illustrates an example of the matrix ops.

XOR computation results, which were calculated when the basis vector candidates of the reception encoding matrix are converted to the basis vectors, are assigned to respective elements of the matrix ops. In the following, a column vector of column number i of the matrix ops is represented by column vector op(i).

In the reception encoding matrix illustrated in FIG. 12, the above update process by XOR computation is performed to convert the column vectors D(13) to D(15) to the basis vectors. The XOR computation results set 1 to the column vectors op(13) to (15) of the matrix ops at elements other than on-diagonal elements of the matrix.

A column vector of this matrix ops is used as a decode vector.

FIG. 16 illustrates an example of a relationship between the column vectors (the decode vectors) of the matrix ops and the data blocks decoded by the column vector.

Note that, in FIG. 16, each of the column vectors op(0) to op(15) of the matrix ops illustrated in FIG. 15 is expressed by a binary number of 32 bits, for convenience.

The elements at the right end of the column vectors op(0) to op(15) are bit 0 and correspond to the elements of the first row of the column vectors op(0) to op(15).

As described above, the values of the column vectors op(0) to op(15) of the matrix ops are the values of the XOR computation results calculated when converting the column vectors of the reception encoding matrix of the corresponding column number to the basis vectors.

The decoding circuit 8a uses these column vectors of the matrix ops as decode vectors, to perform the same process as the XOR computation that is executed to the encoded data or the redundant encoded data to convert the reception encoding matrix to the basis vectors.

A data block decodable with one of the column vectors op(0) to op(15) of the matrix ops corresponds to a row number at which an element of a basis vector is 1 in the reception encoding matrix after update, the basis vector having the same column number as said one of the column vectors op(0) to op(15).

Also, here, the reception encoding matrix is generated from the column vectors of the encoding matrix (FIG. 7), and thus the respective elements of the first to sixteenth rows of the reception encoding matrix correspond to the BRAMs m0 to m15 for storing data blocks, in the same way as the encoding matrix. That is, a data block that is decoded by a column vector of the matrix ops is retained in a BRAM corresponding to a row number at which the element of a basis vector is 1 in the reception encoding matrix after update, the basis vector having the same column number as the column vector.

For example, when a data block is decoded by using the column vector op(2), the column vector D(2) is the column vector of the same column number as the column vector op(2) of the matrix ops, in the reception encoding matrix after update (FIG. 14). Also, the column vector D(2) is a basis vector having the element [5] equal to 1, and thus the block b5 stored in the BRAM m5 corresponding to the row number 5 of the reception encoding matrix is decoded.

When a data block is decoded by using the column vector op(15), the column vector D(15) is the column vector of the same column number as the column vector op(15) of the matrix ops, in the reception encoding matrix after update (FIG. 14). Also, the column vector D(15) is a basis vector having the element [2] equal to 1, and thus the block b2 stored in the BRAM m2 corresponding to the row number 2 of the reception encoding matrix is decoded.

Note that, when there is only a small amount of encoded data that is lost on a transmission route in packet communication, the decode vectors may be calculated in advance and stored in a memory unit in a control circuit (not depicted) for controlling the decoding circuit 8a.

### (Operation of Decoding Circuit 8a)

The decoding circuit 8a illustrated in FIG. 10 retains data blocks (the encoded data (including the redundant encoded data)) in the BRAMs n0 to n29, and the AND circuits a0 to a29 select data blocks for use in computation on the basis of the values of the above decode vector. Then, the XOR computation between the selected data blocks is performed by the XOR circuit unit 22. This parallel processing makes the computation more efficient in the decoding process including many XOR computations, and thereby enables high speed computation.

Note that a reception side device including the decoding circuit 8a may send a decode completion signal to a transmission side device, when the decoding circuit 8a has reproduced (decoded) all of original data blocks. For example, if there is no incompleteness of packets when the reception side device has received a plurality of packets including the encoded data d0 to d15, the reception side device sends a decode completion signal to the transmission side device. The transmission side device stops an encoding process in the encoding circuit 8 illustrated in FIG. 8 at a time point when the transmission side device receives the decode completion signal. Thereby, XOR computation is needless to be performed with regard to all of the column vectors of the RPS encoding matrix illustrated in FIG. 7.

### (Exemplary Variant)

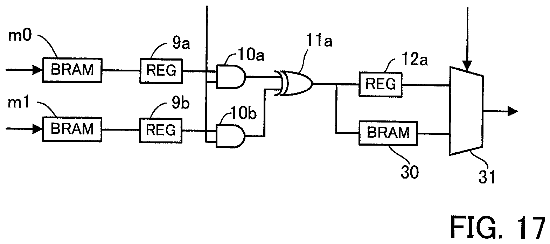

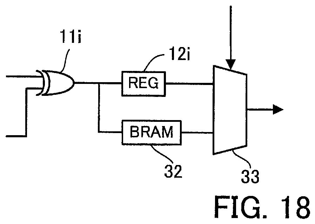

FIGS. 17 and 18 illustrate an exemplary variant of the encoding circuit according to the second embodiment. Note that FIGS. 17 and 18 correspond to parts of the encoding circuit 8 illustrated in FIG. 5. The same reference signs as FIG. 5 are assigned to the same elements as the encoding circuit 8, and their description will be omitted.

In FIG. 17, a BRAM 30 is connected to an output side of the XOR circuit 11a. Also, a selector 31 is connected to output sides of the register 12a and the BRAM 30.

The BRAM 30 retains an XOR computation result of the XOR circuit 11a, that is, a result of XOR computation between the data blocks of the BRAMs m0 to m1. Also, the selector 31 selects one of the register 12a and the BRAM 30 on the basis of an input selection signal and outputs its value. The selection signal is supplied from the control circuit 7 illustrated in FIG. 4, for example.

In FIG. 18, a BRAM 32 is connected to an output side of the XOR circuit 11i. Also, a selector 33 is connected to output sides of the register 12i and the BRAM 32.

The BRAM 32 retains an XOR computation result of the XOR circuit 11i, that is, a result of XOR computation with the data blocks of the BRAMs m0 to m3. Also, the selector 33 selects one of the register 12i and the BRAM 32 on the basis of an input selection signal and outputs its value. The selection signal is supplied from the control circuit 7 illustrated in FIG. 4, for example.

FIGS. 17 and 18 have illustrated an example in which the BRAMs 30 and 32 and the selectors 31 and 33 are provided at the output sides of the XOR circuits 11a and 11i, but the BRAMs 30 and 32 and the selectors 31 and 33 may be provided at the output sides of other XOR circuits 11b to 11h, 11j to n in the same manner.

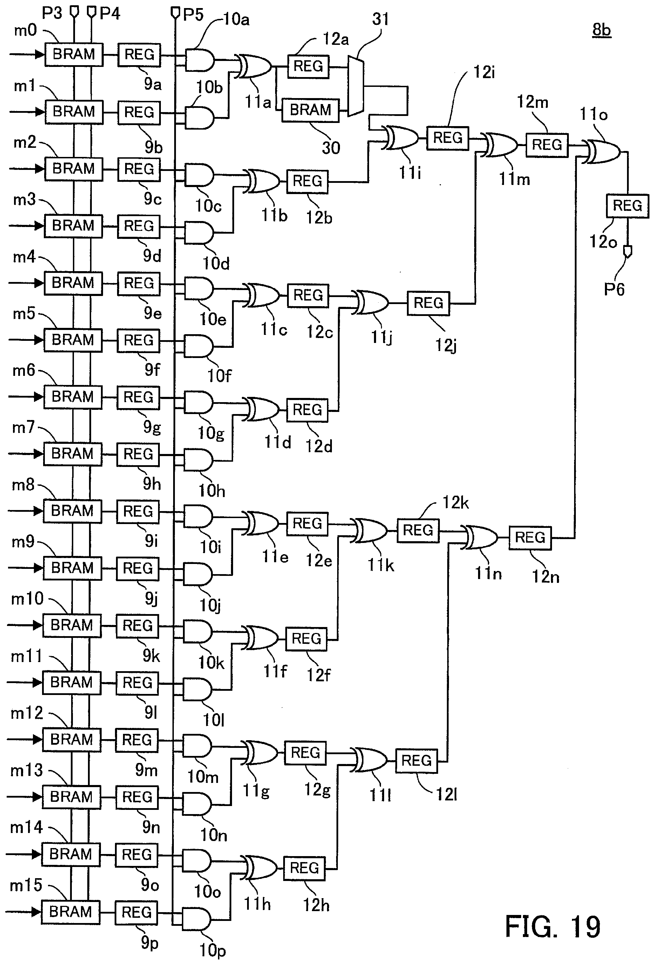

FIG. 19 illustrates an exemplary variant of the encoding circuit according to the second embodiment. Note that the encoding circuit 8b illustrated in FIG. 19 is created by providing a BRAM and a selector in a part of the encoding circuit 8 illustrated in FIG. 5. Also, the same reference signs as the elements illustrated in FIG. 5 are assigned to the same elements as the encoding circuit 8, and their description will be omitted.

The BRAM 30 is connected to the output side of the XOR circuit 11a of the encoding circuit 8b in FIG. 19. Also, the selector 31 is connected to the output sides of the register 12a and the BRAM 30.

The BRAM 30 retains an XOR computation result of the XOR circuit 11a, and the selector 31 selects one of the register 12a and the BRAM 30 on the basis of an input signal and outputs its value. Thereby, the BRAM 30 retains a result of XOR computation between the data blocks retained in the BRAMs m0 and m1, and thus the XOR computation result can be utilized again.

A sequence of an encoding process that uses the encoding circuit 8b illustrated in FIG. 19 will be described below.

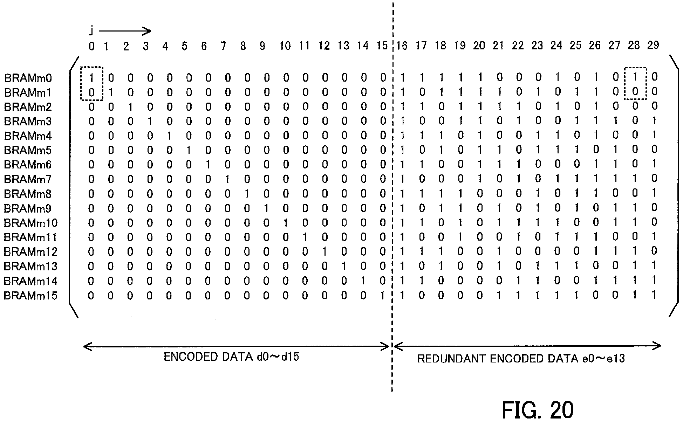

FIG. 20 is a diagram for describing a sequence of an exemplary encoding process.

For example, when a column vector of column number 0 is input into the encoding circuit 8b via the input terminal P5, the BRAM 30 retains a result of XOR computation between the data blocks retained in the BRAMs m0 and m1. In an RPS encoding matrix illustrated in FIG. 20, the same computation as the XOR computation between the data blocks retained in the BRAMs m0 and m1 for the column vector of the column number 0 is also performed for the column vector of the column number 28.

Hence, an XOR computation result retained in the BRAM 30 when the column number of the column vector is 0 can also be utilized in generating encoded data when the column number of the column vector is 28. In this case, the data of the BRAMs m0 to m2 are not used at or after the column vector of the column number 27, and therefore next data blocks can be written into the BRAMs m0 to m2 at or after the column vector of the column number 27. Thereby, throughput of the encoding process can be improved.

Note that the above variant can be applied to the decoding circuit 8a illustrated in FIG. 10 in the same way.

In the above, the encoding circuit and the decoding circuit have been described as an example of the computation circuit for performing XOR computation, but this is not a limitation. For example, the computation circuit can be a device that performs XOR computation a plurality of times (to calculate parity data), as in redundant arrays of inexpensive disks (RAID) 6 for example.

The above just illustrates the principle of the present disclosure. Further, various alterations and modifications can be made by those skilled in the art, and the present disclosure is not limited to the configuration illustrated and described above and application examples thereof, but all variant examples and equivalents thereof are assumed to be within the scope of the present disclosure according to the appended claims and their equivalents.

### Reference Signs List

- 1: computation circuit
- 2a to 2p: selection circuit
- 3a to 3o: XOR circuit
- M0 to M15: memory
- P1: input terminal
- P2: output terminal

## Claims

1. A computation circuit comprising:
a plurality of memories configured to retain data blocks on which exclusive logical OR computation is performed;
a plurality of selection circuits configured to receive a selection signal and select two or more data blocks for use in exclusive logical OR computation from among a plurality of data blocks that are read from the plurality of memories, on the basis of the selection signal; and
one or a plurality of exclusive logical OR computation circuits configured to perform exclusive logical OR computation based on the two or more data blocks selected by the plurality of selection circuits.

2. The computation circuit according to claim 1, wherein
each of the plurality of selection circuits is a logical AND computation circuit that includes a first input terminal for receiving one of the plurality of data blocks retained in the plurality of memories and a second input terminal for receiving the selection signal, and that selects whether or not to output a data block input into the first input terminal on the basis of a value of the selection signal.

3. The computation circuit according to claim 1 or 2, further comprising:
registers connected between the plurality of memories and the plurality of selection circuits, for retaining the data blocks and adjusting when to output the retained data blocks.

4. The computation circuit according to any one of claims 1 to 3, wherein the plurality of exclusive logical OR computation circuits are connected over a plurality of stages, and a memory for storing a result of exclusive logical OR computation is connected to a part of output terminals of the plurality of exclusive logical OR computation circuits.

5. An encoding circuit comprising:
a plurality of memories configured to retain data blocks on which exclusive logical OR computation is performed;
a plurality of selection circuits configured to receive a selection signal and select two or more data blocks for use in exclusive logical OR computation from among a plurality of data blocks that are read from the plurality of memories, on the basis of the selection signal; and
one or a plurality of exclusive logical OR computation circuits configured to generate encoded data by performing exclusive logical OR computation based on the two or more data blocks selected by the plurality of selection circuits.

6. A decoding circuit comprising:
a plurality of memories configured to retain data blocks, the data blocks being encoded data on which exclusive logical OR computation is performed;
a plurality of selection circuits configured to receive a selection signal and select two or more data blocks for use in exclusive logical OR computation from among a plurality of data blocks that are read from the plurality of memories, on the basis of the selection signal; and
one or a plurality of exclusive logical OR computation circuits configured to generate decoded data by performing exclusive logical OR computation based on the two or more data blocks selected by the plurality of selection circuits.
